# EUROPÄISCHE PATENTSCHRIFT

(11) **EP 3 014 663 B1**
(45) Veröffentlichungstag und Bekanntmachung des Hinweises auf die Patenterteilung: **02.09.2020**
(21) Anmeldenummer: 13770893.9
(22) Anmeldetag: 26.09.2013
(51) Int. Cl.: H01L 31/18, H01L 31/068, H01L 21/677, H01L 21/67, F27B 9/06, F27B 9/40

(54) **VERFAHREN UND VORRICHTUNG ZUM HERSTELLEN EINES PHOTOVOLTAIKELEMENTS MIT STABILISIERTEM WIRKUNGSGRAD**
METHOD AND DEVICE FOR PRODUCING A PHOTOVOLTAIC ELEMENT WITH STABILIZED EFFICIENCY
PROCÉDÉ ET DISPOSITIF PERMETTANT DE PRODUIRE UN ÉLÉMENT PHOTOVOLTAÏQUE PRÉSENTANT UN RENDEMENT STABILISÉ

(30) Priorität: 26.06.2013 DE 102013010575
(43) Veröffentlichungstag der Anmeldung: 04.05.2016
(73) Patentinhaber: Universität Konstanz, 78464 Konstanz (DE)
(72) Erfinder: HERGUTH, Axel, 78464 Konstanz (DE); WILKING, Svenja, 89604 Allmendingen (DE)
(74) Vertreter: Qip Patentanwälte Dr. Kuehn & Partner mbB
(86) Internationale Anmeldenummer: PCT/EP2013/070104
(87) Internationale Veröffentlichungsnummer: WO 2014/206504

(56) Entgegenhaltungen:
- EP-A2- 2 863 413
- DE-B3-102006 012 920
- FR-A1- 2 949 607
- FR-A1- 2 966 980
- US-A1- 2008 012 499
- US-A1- 2010 267 188
- US-A1- 2013 102 129
- LIM BIANCA ET AL: "Solar cells on low-resistivity boron-doped Czochralski-grown silicon with stabilized efficiencies of 20%", APPLIED PHYSICS LETTERS, AMERICAN INSTITUTE OF PHYSICS, US, Bd. 93, Nr. 16, 20. Oktober 2008 (2008-10-20), Seiten 162102-162102, XP012111972, ISSN: 0003-6951, DOI: 10.1063/1.3003871
- WILKING S ET AL: "Influence of hydrogen on the regeneration of boron-oxygen related defects in crystalline silicon", JOURNAL OF APPLIED PHYSICS, AMERICAN INSTITUTE OF PHYSICS, 2 HUNTINGTON QUADRANGLE, MELVILLE, NY 11747, Bd. 113, Nr. 19, 21. Mai 2013 (2013-05-21) , Seiten 194503-194503, XP012174152, ISSN: 0021-8979, DOI: 10.1063/1.4804310 [gefunden am 2013-05-17]
- GEORG KRUGEL ET AL: "Impact of Hydrogen Concentration on the Regeneration of Light Induced Degradation", ENERGY PROCEDIA, Bd. 8, 17. April 2011 (2011-04-17), - 20. April 2011 (2011-04-20), Seiten 47-51, XP028263042, ISSN: 1876-6102, DOI: 10.1016/J.EGYPRO.2011.06.100 [gefunden am 2011-08-12]
- R. SØNDENÅ ET AL: "Light Induced Degradation in Monocrystalline Silicon Wafers Made from the Metallurgical Route", PROCEEDINGS OF THE 25TH EUROPEAN PHOTOVOLTAIC SOLAR ENERGY CONFERENCE AND EXHIBITION, 6. September 2010 (2010-09-06), - 10. September 2010 (2010-09-10), Seiten 1586-1590, XP040531032, Valencia-SPAIN DOI: 10.4229/25thEUPVSEC2010-2CV.1.45 ISBN: 978-3-936338-26-3

## Beschreibung

### GEBIET DER ERFINDUNG

Die vorliegende Erfindung betrifft ein Verfahren zum Herstellen eines Photovoltaikelements mit einem durch einen Stabilisierungsbehandlungsschritt stabilisierten Wirkungsgrad. Insbesondere betrifft die vorliegende Erfindung ein Verfahren zum Herstellen einer Solarzelle auf Basis eines Bor-dotierten, Sauerstoff-haltigen Siliziumsubstrats. Ferner betrifft die Erfindung eine Vorrichtung zum Behandeln eines Siliziumsubstrats im Rahmen einer Herstellung eines Photovoltaikelements, wobei die Vorrichtung dazu ausgebildet ist, den Stabilisierungsbehandlungsschritt des erfindungsgemäßen Verfahrens auszuführen.

### TECHNISCHER HINTERGRUND

Solarzellen dienen als photovoltaische Elemente dazu, Licht in elektrischen Strom umzuwandeln. Lichtgenerierte Ladungsträgerpaare, welche beispielsweise an einem pn-Übergang zwischen einem Emitterbereich und einem Basisbereich räumlich getrennt wurden, müssen dabei mithilfe von elektrischen Kontakten der Solarzelle einem äußeren Stromkreis zugeleitet werden. Es müssen hierzu elektrische Kontaktanordnungen sowohl an dem Emitter als auch an der Basis der Solarzelle vorgesehen werden.

Solarzellen werden heute meist auf Basis von Silizium als Halbleitersubstratmaterial gefertigt. Siliziumsubstrate werden dabei häufig in Form monokristalliner oder multikristalliner Wafer bereitgestellt. Es wurde vielfach beobachtet, dass bei Solarzellen, die auf Basis kristalliner Siliziumwafer hergestellt sind, Degradationseffekte auftreten können, die den Wirkungsgrad der Solarzelle mit der Zeit reduzieren. Signifikante Wirkungsgradverluste von bis zu über 1%abs wurden beobachtet.

In der DE 10 2006 012 920 B3 wird ein Verfahren zum Herstellen eines Photovoltaikelements mit stabilisiertem Wirkungsgrad beschrieben. Die dort beschriebene Erfindung geht zumindest teilweise auf die gleichen Erfinder zurück wie die vorliegende Anmeldung. Es wurde damals erkannt, dass der Wirkungsgrad eines Photovoltaikelements stabilisiert werden kann, das heißt einer Degradation vorgebeugt werden kann, indem an dem Photovoltaikelement ein Stabilisierungsbehandlungsschritt durchgeführt wird, bei dem dieses ausreichend lange innerhalb eines erhöhten Temperaturbereichs gehalten wird und gleichzeitig Überschussminoritätsladungsträger in dem Siliziumsubstrat beispielsweise durch Beleuchten oder durch Anlegen einer elektrischen Spannung erzeugt werden.

Allerdings wurde bisher davon ausgegangen, dass Prozessdauern, während derer ein Siliziumsubstrat einem Stabilisierungsbehandlungsschritt unterzogen werden muss, verhältnismäßig lang sein sollten, um eine ausreichende Stabilisierung des Wirkungsgrades erreichen zu können. Dies kann insbesondere bei einer automatisierten industriellen Fertigungslinie zu Verzögerungen und somit zur Bildung eines Flaschenhalses in der Produktion führen.

Weitere Informationen zu Möglichkeiten, Solarzellen herzustellen und dabei eventuell Wirkungsgrade zu beeinflussen oder zu stabilisieren, sind unter anderem angegeben in:
- LIM BIANCA ET AL: "Solar cells on low-resistivity boron-doped Czochralski-grown silicon with stabilized efficiencies of 20%", APPLIED PHYSICS LETTERS, Bd. 93, Nr. 16, 20. Oktober 2008 (2008-10-20), Seiten 162102, XP012111972, ISSN: 0003-6951, DOI: 10.1063/1.3003871;
- W1LK1NGS ET AL: "Influence of hydrogen on the regeneration of boron-oxygen related defects in crystalline silicon", JOURNAL OF APPLIED PHYSICS, Bd. 113, Nr. 19, 21. Mai 2013 (2013-05-21), Seiten 194503-194503, XP012174152, ISSN: 0021-8979, DOI: 10.1063/1.4804310;
- GEORG KRUGEL ET AL: "Impact of Hydrogen Concentration on the Regeneration of Light Induced Degradation", ENERGY PROCED1A, Bd. 8, 17. April 2011 (2011-04-17), - 20. April 2011 (2011-04-20), SEITEN 47-51, XP028263042, ISSN: 1876-6102, DOI: 10.1016/J.EGYPR0.2011.06.100;
- R. S∅NDENÄ ET AL: "LIGHT INDUCED DEGRADATION IN MONOCRYSTALLINE SILICON WAFERS MADE FROM THE METALLURGICAL ROUTE", PROCEEDINGS OF THE 25TH EUPVSEC, 6. SEPTEMBER 2010 (2010-09-06), - 10. SEPTEMBER 2010 (2010-09-10), SEITEN 1586-1590, XP040531032, VALENCIA-SPAIN DOI: 10.4229/25thEUPVSEC2010-2CV.1.45 ISBN: 978-3-936338-26-3
- FR 2 949 607 A1
- US 2013/102129 A1
- EP 2 863 413 A2 (ein Dokument nach Art. 54(3) EPÜ)
- FR 2 966 980 A1

### ZUSAMMENFASSUNG DER ERFINDUNG

Es kann daher ein Bedarf an einem verbesserten Verfahren zum Herstellen eines Photovoltaikelements mit stabilisiertem Wirkungsgrad bestehen. Insbesondere kann ein Bedarf an einem solchen Verfahren bestehen, welches eine Wirkungsgradstabilisierung innerhalb kurzer Prozessdauern ermöglicht. Ferner kann ein Bedarf an einer Vorrichtung zum Behandeln eines Siliziumsubstrats im Rahmen einer Herstellung eines Photovoltaikelements bestehen, welche insbesondere die Durchführung des Stabilisierungsbehandlungsschritts des beschriebenen Verfahrens ermöglicht.

Ein solcher Bedarf kann mit dem Verfahren bzw. der Vorrichtung gemäß den unabhängigen Ansprüchen erfüllt werden. Ausführungsformen der Erfindung sind in den abhängigen Ansprüchen sowie der nachfolgenden Beschreibung dargestellt.

Gemäß einem ersten Aspekt der vorliegenden Erfindung, wie in Anspruch 1 definiert, wird ein Verfahren zum Herstellen eines Photovoltaikelements mit stabilisiertem Wirkungsgrad beschrieben, welches die folgenden Schritte aufweist: Es wird ein Siliziumsubstrat bereitgestellt. An einer Oberfläche des Siliziumsubstrats wird eine Emitterschicht ausgebildet. Ferner werden an dem Siliziumsubstrat elektrische Kontakte ausgebildet. Das Verfahren zeichnet sich dadurch aus, dass ergänzend ein Stabilisierungsbehandlungsschritt durchgeführt wird. Dieser umfasst ein gezieltes Einbringen von Wasserstoff in das Siliziumsubstrat. Nachdem der Wasserstoff in das Siliziumsubstrat eingebracht wurde, werden in dem Siliziumsubstrat Überschussminoritätsladungsträger erzeugt, während das Siliziumsubstrat auf einer Temperatur von über 230°C ist. Der Wasserstoff wird bei Temperaturen oberhalb von 650°C eingebracht und eine anschließende Abkühlung bis auf 450°C wird mit einer Rampe mit einer Abkühlrate oberhalb 550°C von mindestens 10 K/s durchgeführt.

Gemäß einem zweiten Aspekt der vorliegenden Erfindung, wie in Anspruch 12 definiert, wird eine Vorrichtung zum Behandeln eines Siliziumsubstrats im Rahmen einer Herstellung eines Photovoltaikelements beschrieben, wobei die Vorrichtung dazu ausgebildet ist, den Stabilisierungsbehandlungsschritt des erfindungsgemäßen Verfahrens durchzuführen.

Die Vorrichtung ist als Durchlaufofen mit einer Mehrzahl unterschiedlich temperierbarer Zonen ausgebildet und weist eine Beleuchtungseinrichtung auf, mit Hilfe derer Minoritätsladungsträger in dem Siliziumsubstrat erzeugt werden können. Die Zonen können dabei derart temperierbar sein und die Vorrichtung einschließlich der Beleuchtungseinrichtung derart ausgebildet sein, dass ein den Durchlaufofen durchlaufendes Siliziumsubstrat in einer Hochtemperaturzone zunächst kurzzeitig auf eine Temperatur von oberhalb 650°C erhitzt wird, dann in einer Abkühlzone mit einer Abkühlrate oberhalb 550°C von mindestens 10 K/s auf eine Temperatur unterhalb von 450°C abgekühlt wird und dann in einer Temperaturhaltezone bei einer Temperatur von zwischen 230°C und 450°C gehalten wird, optional für wenigstens 10s, und gleichzeitig oder nachfolgend das Siliziumsubstrat bei einer Temperatur von über 230°C, mit einer Beleuchtungsintensität größer 0,3 kW/m² beleuchtet wird.

Ohne den Schutzbereich der Erfindung einzuschränken, können Ideen zu Ausführungsformen des erfindungsgemäßen Verfahrens bzw. der erfindungsgemäßen Vorrichtung als unter anderem auf den nachfolgend beschriebenen Gedanken und Erkenntnissen beruhend angesehen werden:
Die Möglichkeit, ein im Rahmen der Herstellung eines Photovoltaikelements verwendetes Siliziumsubstrat mittels eines geeigneten Stabilisierungsbehandlungsschrittes gegen eine nachfolgende, im Betrieb des Photovoltaikelements ansonsten auftretende Degradation zu schützen bzw. zu stabilisieren, manchmal auch als Regeneration bezeichnet, ist seit längerem bekannt. Details dazu, wie ein Stabilisierungsbehandlungsschritt durchgeführt werden kann und welche Wirkungsmechanismen dahinter vermutet werden, wurden ausführlich in der DE 10 2006 012 920 B3 beschrieben.

Es wurde nun erkannt, dass mithilfe zusätzlicher Prozessschritte oder geeignet gewählter Prozessparameter die Regenerationsrate während des Stabilisierungsbehandlungsschritts erheblich erhöht werden kann und somit die Dauer, über die der Stabilisierungsbehandlungsschritt durchgeführt werden sollte, um eine ausreichende Wirkungsgradstabilisierung für das letztendlich hergestellte Photovoltaikelement zu erreichen, möglichst kurz gehalten werden kann.

Insbesondere wurde beobachtet, dass eine Regenerationsrate maßgeblich davon abzuhängen scheint, welche Mengen an Wasserstoff in dem Siliziumsubstrat während des eigentlichen Regenerierungsvorganges, das heißt während Überschussminoritätsladungsträger bei erhöhter Substrattemperatur in dem Siliziumsubstrat erzeugt werden, vorhanden sind. Ferner scheint wichtig zu sein, wie der Wasserstoff innerhalb des Siliziumsubstrats verteilt ist und in welchem Bindungszustand sich dieser Wasserstoff innerhalb des Siliziumsubstrats befindet.

Es wird daher vorgeschlagen, zunächst gezielt Wasserstoff in das Siliziumsubstrat einzubringen. Dies kann, wie weiter unten detaillierter beschrieben, auf unterschiedliche Weise erfolgen. Anschließend hat es sich als vorteilhaft herausgestellt, das Siliziumsubstrat zumindest kurzzeitig, beispielsweise über wenigstens 5s oder wenigstens 10s, innerhalb eines Temperaturbereichs von 230°C bis 450°C zu halten. Eine Haltedauer scheint dabei umso kürzer wählbar zu sein, je höher die gehaltene Temperatur des Siliziumsubstrats ist. Es wird vermutet, dass dieses Halten des Siliziumsubstrats bei erhöhter Temperatur sich vorteilhaft auf den Bindungszustand des zuvor eingebrachten Wasserstoffs auswirkt. Anschließend kann der eigentliche Regenerationsvorgang durchgeführt werden, indem Überschussminoritätsladungsträger in dem Siliziumsubstrat erzeugt werden, während dieses auf einer erhöhten Temperatur von wenigstens mehr als 230°C und vorzugsweise jedoch weniger als 450°C, gehalten wird. Gegebenenfalls können die Überschussminoritätsladungsträger in dem Siliziumsubstrat bereits während des zuvor beschriebenen Haltens des Siliziumsubstrats innerhalb des Temperaturbereichs von zwischen 230°C und 450°C erzeugt werden.

Es wurde beobachtet, dass durch das gezielte Einbringen von Wasserstoff und das anschließende Regenerieren bei erhöhter Temperatur der Regenerationsvorgang erheblich beschleunigt werden kann. Statt, wie bisher vermutet, wenigstens mehrere Minuten hierfür zu benötigen, wird davon ausgegangen, dass die Regeneration innerhalb weniger Sekunden durchgeführt werden kann und der gesamte Stabilisierungsbehandlungsschritt somit geeignet innerhalb einer einzigen Vorrichtung wie beispielsweise einem Durchlaufofen durchgeführt werden kann.

Dies kann beispielsweise ermöglichen, innerhalb einer häufig industriell eingesetzten Herstellungssequenz, bei der Siebdruckkontakte in einem Durchlaufofen eingefeuert werden, den Durchlaufofen derart zu modifizieren, dass gleichzeitig auch der Stabilisierungsbehandlungsschritt durchgeführt werden kann. Mittels eines solchen geeignet modifizierten Durchlaufofens kann somit sowohl eine Kontaktbildung durch Einfeuern siebgedruckter Metallpastenstrukturen als auch eine Regeneration des Siliziumsubstrats und somit eine Stabilisierung des Wirkungsgrads der letztendlich hergestellten Solarzelle simultan durchgeführt werden.

Der Wasserstoff wird bei Temperaturen oberhalb von 650°C, eingebracht und eine anschließende Abkühlung bis auf 450°C wird mit einer Rampe mit einer Abkühlrate oberhalb 550°C von mindestens 10 K/s, vorzugsweise mindestens 20 K/s, stärker bevorzugt mindestens 30 K/s und noch stärker bevorzugt mindestens 60 K/s durchgeführt. Mit anderen Worten kann das Siliziumsubstrat zunächst auf über 650°C erhitzt werden, um den Wasserstoff einzutreiben, und dann schnell auf unter 450°C abgekühlt werden, wobei zumindest die Abkühlung bis auf 550°C besonders rapide erfolgen soll mit einer Abkühlrate von wenigstens 10 K/s.

Wasserstoff kann bei hohen Temperaturen von deutlich über 450°C, insbesondere über 550°C, sehr schnell, das heißt innerhalb weniger Sekunden oder Sekundenbruchteile, in das Siliziumsubstrat eindiffundieren und sich in diesem vorzugsweise möglichst homogen verteilen. Beispielsweise kann Wasserstoff aus einer auf dem Siliziumsubstrat aufgebrachten wasserstoffhaltigen Schicht bei ausreichend hohen Temperaturen schnell in das darunterliegende Siliziumsubstrat eindiffundieren.

Allerdings wurde die Gefahr erkannt, dass für den Fall, dass die hohen Temperaturen zu lange vorherrschen und sich die Wasserstoffquelle mit der Zeit erschöpft, Wasserstoff auch wieder aus dem Siliziumsubstrat herausdiffundieren kann, das heißt, dass es zu einer Effusion von Wasserstoff kommen kann. Insbesondere an der Oberfläche des Siliziumsubstrats, das heißt, dort wo sich bei der fertigen Solarzelle beispielsweise die Emitterschicht befindet und die Solarzelle somit besonders empfindlich gegenüber defekt-begründeten Degradationseffekten ist, kann es zu einer Verarmung von Wasserstoff kommen. Da der Wasserstoff eine nachfolgend durchzuführende Regeneration maßgeblich zu unterstützen scheint, sollte daher eine Wasserstoffeffusion möglichst weitgehend vermieden werden.

Es wird daher vorgeschlagen, nach einem Einbringen von Wasserstoff bei ausreichend hoher Temperatur, die Temperatur sehr schnell zu reduzieren, das heißt, das Siliziumsubstrat mit einer hohen Abkühlrate bis unter 450°C abzukühlen, um den Zeitraum, innerhalb dessen Wasserstoff aus dem Siliziumsubstrat herausdiffundieren könnte, möglichst kurz zu halten. Ein solches schnelles Abkühlen ist insbesondere dann anzustreben, wenn die Wasserstoffquelle zu erschöpfen droht, d.h. kein Wasserstoff z.B. nach einer zu langen Hochtemperaturphase mehr nachgeliefert werden kann, oder wenn die Wasserstoffquelle z.B. wegen zu geringer Temperaturen keinen Wasserstoff mehr freisetzen kann.

Nachfolgend kann das Siliziumsubstrat dann bei Temperaturen von unterhalb 450°C ausreichend lange gehalten werden, wobei bei diesen verhältnismäßig niedrigen Temperaturen eine Effusion von Wasserstoff kaum auftritt, der Wasserstoff vermutlich aber einen für eine Regeneration förderlichen Bindungszustand innerhalb des Siliziumsubstrats einnehmen kann.

Gemäß einer Ausführungsform können die Überschussminoritätsladungsträger während der Regeneration durch Beleuchten mit einer Beleuchtungsintensität größer 0,3 kW/m², vorzugsweise größer 1 kW/m², stärker bevorzugt größer 3 kW/m² mit Licht mit Wellenlängen kleiner als 1180 nm erzeugt werden.

Es wurde beobachtet, dass eine Regeneration umso schneller erfolgt, das heißt eine Regenerationsrate umso größer ist, je höher eine Dichte an Überschussminoritätsladungsträgern ist. Überschussminoritätsladungsträger können unter anderem durch Beleuchtung innerhalb des Siliziumsubstrats generiert werden. Eine hohe Beleuchtungsintensität kann somit eine schnelle Regeneration unterstützen.

Gemäß einer Ausführungsform können die Überschussminoritätsladungsträger bei einer Temperatur des Siliziums von zwischen 230°C und 450°C, vorzugsweise zwischen 230°C und 400°C und stärker bevorzugt zwischen 230°C und 350°C und noch stärker bevorzugt zwischen 230°C und 300°C erzeugt werden.

Während bisher davon ausgegangen wurde, dass eine Regenerationsrate zwar zunächst mit zunehmender Temperatur oberhalb von 50°, insbesondere oberhalb von 90°C ansteigt, oberhalb von etwa 180°C dann aber wieder abzunehmen schien, vermutlich aufgrund konkurrierender Effekte, wurde nun erkannt, dass durch ein vorheriges Einbringen von Wasserstoff und optional ein anschließendes Halten des Siliziumsubstrats bei geeigneter Temperatur über eine geeignet lange Zeitdauer das Siliziumsubstrat offenbar derart vorbehandelt werden kann, dass ein Regenerationsvorgang auch bei höheren Temperaturen oberhalb von 230°C durchgeführt werden kann. Mit höherer Temperatur scheint dabei eine Regeneration schneller abzulaufen. Entgegenwirkende, konkurrierende Effekte scheinen durch den zuvor eingebrachten Wasserstoff und die Temperaturvorbehandlung schwächer auszufallen oder deutlich langsamer zu wirken als die aufgrund der Vorbehandlung beschleunigt ablaufenden, die Regeneration bewirkenden Effekte. Daher scheinen diese konkurrierenden Effekte erst bei wesentlich höheren Temperaturen von beispielsweise deutlich über 300°C den Regenerationseffekten erheblich entgegenzuwirken. Insgesamt kann somit eine Regeneration des Siliziumsubstrats aufgrund der Vorbehandlung und der dadurch ermöglichten wesentlich höheren Temperaturen während des eigentlichen Regenerationsvorgangs erheblich beschleunigt werden.

Gemäß einer Ausführungsform kann das vorgestellte Verfahren ein Abscheiden einer wasserstoffhaltigen Schicht auf eine Oberfläche des Siliziumsubstrats umfassen, wobei diese Schicht bei dem Einbringen von Wasserstoff in das Siliziumsubstrat als Wasserstoffquelle dienen kann.

Ein solches Abscheiden einer wasserstoffhaltigen Schicht ist technologisch einfach durchführbar. Beispielsweise kann die wasserstoffhaltige Schicht als hydrogenierte Siliziumnitridschicht, das heißt als eine mit Wasserstoff versetzte Siliziumnitridschicht, ausgebildet werden. Eine solche Schicht kann beispielsweise mittels industriell erprobter Verfahren wie zum Beispiel PECVD (plasma enhanced chemical vapour deposition) abgeschieden werden. Aus der wasserstoffhaltigen Schicht kann Wasserstoff bei erhöhten Temperaturen in das Siliziumsubstrat eindiffundieren.

Gemäß einer Ausführungsform kann die wasserstoffhaltige Schicht mit mindestens einer weiteren Diffusionsbarrierenschicht bedeckt sein, die weniger durchlässig für Wasserstoff ist als die wasserstoffhaltige Schicht selbst. Die weitere Schicht kann dabei zum Beispiel während des Einbringens von Wasserstoff in das Siliziumsubstrat bei hohen Temperaturen als nach außen hin wirkende Diffusionsbarriere wirken, so dass Wasserstoff zwar von der wasserstoffhaltigen Schicht in das Siliziumsubstrat, kaum aber in die umgebende Atmosphäre hin diffundieren kann. Die Diffusionsbarrierenschicht kann beispielsweise mit einem Dielektrikum ausreichender Dichte ausgebildet werden.

Gemäß einer Ausführungsform kann das mit der wasserstoffhaltigen Schicht beschichtete Siliziumsubstrat anschließend in einem Durchlaufofen durch geeignet temperierte Zonen gefahren werden.

Bei einer solchen besonders einfach industriell implementierbaren Ausgestaltung des Verfahrens kann beispielsweise nachdem die Emitterschicht an der Oberfläche des Siliziumsubstrats ausgebildet wurde, eine wasserstoffhaltige Dielektrikumschicht wie zum Beispiel eine hydrogenierte Siliziumnitridschicht an der Oberfläche des Siliziumsubstrats abgeschieden werden. Diese Schicht kann in geeigneter Dicke abgeschieden werden, so dass sie nachfolgend auch als beispielsweise Antireflexschicht, Passivierungsschicht oder dielektrischer Spiegel für die Solarzelle wirken kann. Ohne großen Mehraufwand kann hierbei auch z.B. eine dichtere SiNₓ:H-Schicht als Diffusionsbarriereschicht aufgebracht werden, indem beispielsweise Gasflüsse von Silan und Ammoniak (als Precursor-Gase) entsprechend angepasst werden. Es kann so auch eine möglicherweise vorteilhafte Doppelantireflexionsbeschichtung bei passender Wahl der Dicken entstehen.

Anschließend können gegebenenfalls Siebdruckkontaktstrukturen auf diese Schicht aufgedruckt werden. In einem gemeinsamen Hochtemperaturschritt werden die derart vorbereiteten Siliziumsubstrate dann durch einen Durchlaufofen geschickt und dabei verschiedene Temperaturzonen durchfahren, so dass einerseits die Siebdruckkontakte eingefeuert werden können und andererseits durch Einstellen eines geeigneten Temperaturprofils innerhalb des Durchlaufofens simultan auch zumindest Teile des Stabilisierungsbehandlungsschritts durchgeführt werden, um insgesamt den Wirkungsgrad der Solarzelle zu stabilisieren. Beispielsweise kann ein Eindringen des in der wasserstoffhaltigen Schicht enthaltenen Wasserstoffs in das Siliziumsubstrat während des Feuerschritts bei über 650°C erfolgen, anschließend das Substrat schnell auf unter 550°C, vorzugsweise auf unter 450°C abgekühlt werden und dort dann für eine Zeitdauer von beispielsweise wenigstens 10s bei Temperaturen von vorzugsweise unter 450°C gehalten werden. Mit einer solchen Vorbehandlung bereits innerhalb des Durchlaufofens kann dann die eigentliche Regeneration durch Erzeugen von Überschussminoritätsladungsträgern bei erhöhter Temperatur durchgeführt werden.

Gemäß einer Ausführungsform können die Überschussminoritätsladungsträger in einem anschließenden Verfahrensschritt z.B. nach dem Halten des Siliziumsubstrats innerhalb des Temperaturbereichs von 230°C bis 450°C erzeugt werden. Mit anderen Worten kann nach dem Einbringen von Wasserstoff in das Siliziumsubstrat das Siliziumsubstrat zunächst bei erhöhter Temperatur gehalten werden, ohne dass Überschussminoritätsladungsträger erzeugt werden. Das hydrogenierte Siliziumsubstrat wird somit zunächst nur vorbehandelt und der eigentliche Regenerationsprozess wird nachfolgend separat, in der gleichen Vorrichtung oder in einer anderen Vorrichtung, durchgeführt.

Alternativ können gemäß einer Ausführungsform die Überschussminoritätsladungsträger in einem gemeinsamen Verfahrensschritt zusammen mit dem Halten des Siliziumsubstrats innerhalb des Temperaturbereichs von 230°C bis 450°C erzeugt werden. Mit anderen Worten wurde beobachtet, dass der Schritt des Haltens des Siliziumsubstrats bei 230 bis 450°C mit dem Schritt des Erzeugens von Überschussminoritätsladungsträgern bei Temperaturen oberhalb von 230°C, kombiniert werden kann. Überschussminoritätsladungsträger können dabei in dem Siliziumsubstrat bereits erzeugt werden, beispielsweise durch Beleuchten, solange das Siliziumsubstrat noch bei 230 bis 450°C gehalten wird. Insgesamt lässt sich hierdurch eine erhebliche zeitliche Verkürzung des Stabilisierungsbehandlungsschritts erwarten.

Gemäß einer Ausführungsform kann eine Vorrichtung, die speziell für die Durchführung des Stabilisierungsbehandlungsschritts im Rahmen einer Herstellung eines Photovoltaikelements ausgelegt ist, eine Kühlvorrichtung zum aktiven Kühlen des Siliziumsubstrats innerhalb einer Abkühlzone aufweisen. Unter einem aktiven Kühlen kann dabei verstanden werden, dass das Siliziumsubstrat nicht hauptsächlich durch Abstrahlung passiv Wärme an die Umgebung abgibt, sondern ein Wärmeverlust des Siliziumsubstrats durch weitere Maßnahmen und/oder Effekte wie zum Beispiel erzwungene Konvektion aktiv unterstützt wird.

Gemäß einer Ausführungsform kann die Kühlvorrichtung beispielsweise ein Gebläse zum Einblasen eines kühlenden Gases in die Abkühlzone aufweisen. Beispielsweise kann die Kühlvorrichtung dazu ausgelegt sein, reaktionsträges Gas, zum Beispiel Stickstoff, gezielt lokal in die Abkühlzone einzublasen. Das Gas kann dabei eine niedrige Temperatur, beispielsweise im Bereich der Umgebungstemperatur, vorzugsweise zumindest deutlich unter 100°C, zumindest aber jedoch deutlich unter 300°C, aufweisen. Die Temperatur und ein Fluss des eingeblasenen Gases können geeignet gewählt werden, so dass es innerhalb der Abkühlzone zu einer gewünschten hohen Abkühlrate für das Siliziumsubstrat von beispielsweise mehr als 60 K/s kommt.

Es wird darauf hingewiesen, dass mögliche Merkmale und Vorteile von Ausführungsformen der Erfindung hierin teilweise mit Bezug auf ein erfindungsgemäßes Verfahren und teilweise mit Bezug auf eine erfindungsgemäße Vorrichtung beschrieben sind. Ein Fachmann wird erkennen, dass die beschriebenen Merkmale in geeigneter Weise ausgetauscht oder kombiniert werden können und insbesondere auch von dem Verfahren in analoger Weise auf die Vorrichtung bzw. umgekehrt übertragen werden können.

Ein Fachmann wird ferner erkennen, dass ein erfindungsgemäßes Verfahren zum Herstellen eines Photovoltaikelements noch weitere Verfahrensschritte umfassen kann, beispielsweise Reinigungsschritte, Schritte zur Bildung geeigneter dielektrischer Schichten als Antireflexschichten, Passivierungsschichten, Spiegelschichten, etc., weitere Schritte zur Bildung von elektrischen Kontakten oder zusätzlicher dotierter Bereiche innerhalb des Siliziumsubstrats, usw. Auch die beschriebene Vorrichtung zur Durchführung des Stabilisierungsbehandlungsschritts kann über die beschriebenen Merkmale hinaus weitere strukturelle und funktionale Merkmale aufweisen, wie sie beispielsweise bei der Herstellung einer Siliziumsolarzelle vorteilhaft eingesetzt werden können.

### KURZE BESCHREIBUNG DER ZEICHNUNGEN

Die vorangehend beschriebenen und weitere mögliche Aspekte, Merkmale und Vorteile der Erfindung werden aus der nachfolgenden Beschreibung spezifischer Ausführungsformen unter Bezugnahmen auf die beigefügten Zeichnungen ersichtlich, wobei weder die Beschreibung noch die Zeichnungen als die Erfindung einschränkend auszulegen sind.
Fig. 1 zeigt ein Drei-Zustand-Modell, mit dem Defektzustände innerhalb eines Siliziumsubstrats und damit zusammenhängende Übergänge zwischen einzelnen Zuständen wie beispielsweise eine Degradation oder eine Regeneration erklärt werden können.
Fig. 2 zeigt eine Vorrichtung zum Behandeln eines Siliziumsubstrats im Rahmen einer Herstellung eines Photovoltaikelements gemäß einer Ausführungsform der vorliegenden Erfindung.
Fig. 3 zeigt ein Temperaturprofil eines Substrates während des Durchlaufs durch die in Fig. 2 dargestellte Vorrichtung.

Die Figuren sind lediglich schematisch und nicht maßstabsgetreu. Gleiche Bezugszeichen bezeichnen in den Figuren gleiche oder gleich wirkende Merkmale.

### BESCHREIBUNG BEVORZUGTER AUSFÜHRUNGSFORMEN DER ERFINDUNG

Im Weiteren beschriebene Ausführungsformen der Erfindung betreffen im weitesten Sinne ein Verfahren zur Passivierung bzw. Unschädlichmachung von elektrisch aktiven Defekten in Silizium-basierten Photovoltaikelementen wie z.B. Solarzellen bzw. Solarmodulen. Insbesondere kann es sich bei den Defekten um Bor-Sauerstoff korrelierte Defekte handeln, wie sie in der Literatur beschreiben werden, welche eine Qualität (beschrieben durch die (statistische) Lebensdauer der Minoritätsladungsträger) von Ausgangsmaterial und davon abhängige elektrische Leistungsparameter der Solarzelle (Strom, Spannung, Wirkungsgrad unter Beleuchtung) vor allem von monokristallinen aber auch allgemein multikristallinem Silizium bzw. Solarzellen erheblich senken können. Eine Wirkung des hierin vorgeschlagenen Verfahrens auch auf andere Defekte ist nicht auszuschließen.

Eine Solarzelle bzw. ein Solarmodul wird dazu verwendet, Energie von eintreffendem ultraviolettem/sichtbarem/infrarotem Licht direkt in elektrisch nutzbare Energie umzuwandeln, ohne Wärme als Zwischenform zu verwenden. Dazu nutzt man den inneren Photoeffekt aus, bei dem Elektronen in einem halbleitenden Material (z.B. Silizium) von elektromagnetischer Strahlung über eine energetisch verbotene Bandlücke hinweg angeregt werden und somit zumindest eine Energie entsprechend der Bandlücke des Halbleiters aufnehmen. Der Fachmann spricht in diesem Zusammenhang von der Anregung eines Elektron-Loch Paares, weil das angeregte (jetzt bewegliche) Elektron sein ursprüngliches Atom verlässt und dem ursprünglichen (neutralen) Atom daraufhin eine überschüssige positive Ladung (ein "fehlendes" Elektron = Loch) verbleibt. Wird das angeregte, bewegliche Elektron wieder von einem (positiv geladenen) Atom eingefangen, so geht die zwischenzeitlich gespeicherte Energie (entsprechend der Bandlücke) wieder verloren. Der Fachmann spricht in diesem Falle von der Rekombination eines Elektron-Loch Paares. Ein Rekombinationsvorgang erfordert zwingend zumindest ein Elektron und ein Loch.

Um die eingefangene Energie des Lichts nutzbar zu machen, müssen Elektronen und Löcher voneinander getrennt werden. Dies wird in einer typischen Solarzelle dadurch realisiert, dass in dem Bauteil ein elektronenreicher (n-Typ dotierter) Bereich und ein elektronenverarmter, löcherreicher (p-Typ dotierter) Bereich aneinander grenzen und sich ein sogenannter pn-Übergang ausbildet. Aufgrund der Konzentrationsunterschiede an beweglichen Elektronen bzw. Löchern in den angrenzenden Bereichen und der daraus folgenden Diffusion der Ladungsträger, bildet sich ein Potentialgefälle im pn-Übergang aus. Dieses Potentialgefälle ermöglicht eine räumliche Trennung von Elektron-Loch Paaren, wodurch die Rekombination unterbunden wird und die gespeicherte Energie einem externen Verbraucher über entsprechend arrangierte, nach Polarität getrennte metallische Kontakte zur Verfügung gestellt werden kann. Eine weitergehende Beschreibung ist der gängigen Literatur zu entnehmen.

Damit es zu dieser räumlichen Trennung eines Elektron-Loch Paares kommen kann, muss der Minoritätsladungsträger, d.h. der Ladungsträger, der zum Halbleitertyp des Absorbermaterials eines Halbleitersubstrats komplementär ist, aus dem Absorbermaterial in den Bereich des pn-Übergangs diffundieren können. Weist das Absorbermaterial eine Vielzahl an rekombinationsaktiven Defekten auf, welche Elektronen und Löcher wechselweise aneinander binden können und damit einen Rekombinationsprozess bewirken, dann geht ansonsten elektrisch nutzbare Energie für den externen Verbraucher verloren und die elektrische Leistungsfähigkeit der Solarzelle verschlechtert sich.

Die Dichte der Defekte bzw. die daraus resultierende (gut messbare) mittlere Lebensdauer eines Elektron-Loch Paares ist daher eine maßgebliche Größe für die Qualität eines Halbleiter-Materials und eine elektrische Leistungsfähigkeit der daraus hergestellten Solarzellen.

Für Solarzellen kann kristallines Silizium als Absorbermaterial dienen, in dem Elektron-Loch Paare generiert werden. Der Fachmann unterscheidet hierbei zwischen monokristallinem und multikristallinem Material, wobei multikristallines Material aufgrund des verwendeten Herstellungsverfahrens aus einer Vielzahl einzelner Kristallite zusammengesetzt ist. Die unterschiedlichen Herstellungsverfahren bedingen dabei unterschiedliche Eigenschaften des Materials.

Bei monokristallinem Silizium kommt zumeist das Verfahren nach Czochralski (Cz-Si) zum Einsatz, bei dem ein Silizium-Einkristall aus der Siliziumschmelze gezogen wird. Das verwendete Rohsilizium ist zumeist hochrein und weist keine nennenswerte Kontamination insbesondere mit Sauerstoff auf. Beim Czochralski-Verfahren kommt allerdings nach derzeitigem Stand der Technik ein eventuell beschichteter Quarztiegel (SiO2) zum Einsatz, der durch die hohe chemische Reaktivität des Siliziums, die verwendeten Temperaturen (Schmelztemperatur von Silizium: 1410°C), die Konvektion in der Schmelze und die Tiegelrotation angegriffen und teilweise in die Restschmelze gelöst wird. Dies führt im Allgemeinen dazu, dass sich unerwünscht Sauerstoff aus dem Quarztiegel in der Schmelze anreichert und in den Silizium-Einkristall als Fremdstoff eingebaut wird. Typischerweise liegt der interstitielle Sauerstoffgehalt von Cz-Si im Bereich von 5×1017 bis 3×1018 cm-3. Die obere Grenze ist hierbei durch die Löslichkeit gegeben. Nur durch fortgeschrittene Verfahren, z.B. mit Hilfe von Magnetfeldern, welche die Konvektion in der Schmelze stören, können beim Czochralski-Verfahren geringere Sauerstoffkonzentrationen zuverlässig im gesamten Kristall erreicht werden.

Monokristallines Material hergestellt nach dem "Floatzone"-Verfahren, welches hochreine und insbesondere auch sauerstoffarme Siliziumeinkristalle vor allem für die Elektronikindustrie liefert, kommt aufgrund der hohen Kosten bei der Herstellung von Silizium-basierten Solarzellen selten zum Einsatz.

Multikristallines Silizium wird in der Regel in einem abweichenden Prozess hergestellt, bei dem eine Siliziumschmelze in einer (beschichteten) Quarzform gerichtet kristallisiert wird (z.B. Bridgeman-Verfahren), wobei sich hierbei in der Regel anstelle eines Einkristalls eine Vielzahl an Kristalliten bilden. Im Gegensatz zum Czochralski-Verfahren rotiert die Schmelze in diesem Fall nicht und die Konvektionsbewegung fällt geringer aus. Aus diesem Grund wird die verwendete Quarzform weniger von der Siliziumschmelze angegriffen und weniger Sauerstoff gelangt in die Siliziumschmelze. Je nach Verfahren fällt der Sauerstoffgehalt des multikristallinen Materials geringer aus als beim Czochralski-Verfahren und liegt typischerweise im Bereich von 5×1016 bis 5×1017 cm-3. Bei entsprechender Umsetzung können die Kristallite allerdings die Größe der später hergestellten Solarzellen erreichen, so dass es sich praktisch um einkristallines Material handelt. Der Fachmann spricht hierbei von quasi-monokristallinem Material, welches aber im Vergleich zu nach Czochralski-Verfahren hergestellten Materialien einen geringeren Sauerstoffgehalt aufweisen kann.

Oftmals fällt die Qualität des multikristallinen Materials geringer aus als die vergleichbaren monokristallinen Materials, da die Korngrenzen zwischen benachbarten Kristalliten als starke Rekombinationszentren wirken und prozesstechnisch problematisch sein können. Dies führt dazu, dass monokristalline Solarzellen in der Regel höhere Wirkungsgrade aufweisen als vergleichbare multikristalline Solarzellen.

Um einen pn-Übergang erzeugen zu können, muss das Absorbermaterial dotiert sein. Das Material kann entweder elektronenreich (n-Typ) hergestellt werden, wobei zumeist Phosphor als Dotierstoff gewählt wird, oder löcherreich (p-Typ) hergestellt werden, wobei zumeist Bor oder Gallium als Dotierstoff gewählt wird. Aufgrund seines besseren (nahezu gleichen) Löslichkeitsverhaltens in Kristall und Schmelze verteilt sich Bor allerdings gleichmäßiger als Gallium entlang der Wachstumsrichtung des Siliziumkristalls und ist daher als Dotierstoff weiter verbreitet als Gallium. Auch beabsichtigte oder unbeabsichtigte Mischdotierungen sind üblich. Übliche Dotierungen bewegen sich im Bereich von 1×1014 bis 1×1017 cm-3, wobei der konkret verwendete Wert von der Polarität des Absorbermaterials und von der Architektur der Solarzelle abhängt.

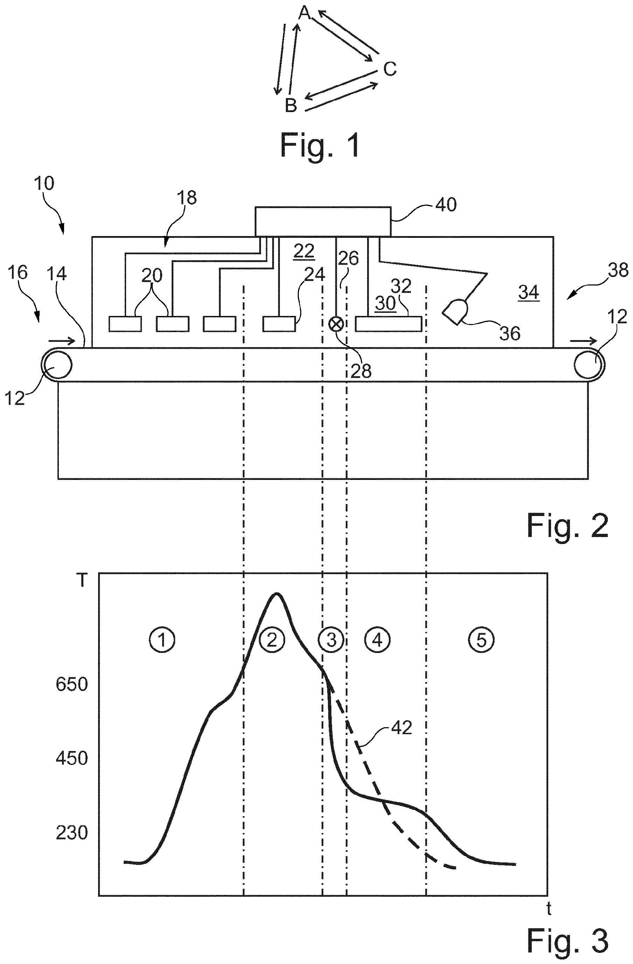

Es ist weiterhin bekannt, dass sich bei gleichzeitiger Präsenz von Bor und Sauerstoff im Siliziumkristall Bor-Sauerstoff korrelierte Defekte unter Beleuchtung bzw. Ladungsträgerinjektion selbst bei Raumtemperatur binnen Stunden, d.h. bei typischen Arbeitsbedingungen von Solarzellen und -modulen, ausbilden bzw. sich aktivieren können, welche als stark rekombinationsaktive Zentren die Lebensdauer der Minoritätsladungsträger und damit auch die elektrische Leistungsfähigkeit der Solarzelle/des Solarmoduls limitieren können. Der Fachmann spricht in diesem Zusammenhang von Bor-Sauerstoff korrelierter Degradation (siehe Figur 1: Übergang vom inaktiven (annealten) Zustand A durch Degradation zum aktiven (degradierten) Zustand B) bzw. der Limitierung durch Bor-Sauerstoff korrelierte Defekte. Gebräuchlich ist in diesem Zusammenhang auch die weniger präzise Bezeichnung Licht-induzierte Degradation, welche nicht nur durch Bor-Sauerstoff korrelierte Defekte, sondern auch auf andere Licht-induzierte Defekte zurückzuführen ist.

Die aktivierten und damit rekombinationsaktiven Bor-Sauerstoff korrelierten Defekte (siehe Figur 1: Zustand B) lassen sich durch eine Erwärmung für kurze Zeit auf 100-200 oder 100 - 300°C im Dunkeln wieder in einen rekombinationsinaktiven Zustand überführen (siehe Figur 1: Übergang vom aktiven Zustand B durch Anneal zum inaktiven Zustand A). Bei erneuter Beleuchtung bzw. Ladungsträgerinjektion läuft die Bor-Sauerstoff korrelierte Degradation allerdings erneut ab, weshalb die Defekte auch metastabil genannt werden.

Die Dichte der (aktivierten) Defekte hängt hierbei in etwa linear von der Borkonzentration und in etwa quadratisch von der Sauerstoffkonzentration im Siliziumsubstrat ab. Insbesondere betrifft dieser Effekt daher Bor-dotierte sauerstoffreiche Siliziummaterialien, die nach dem Czochralski-Verfahren hergestellt wurden. Bei Solarzellen basierend auf hochdotierten (Borgehalt 1×1016 oder wenigstens 2 x 1015 cm-3), sauerstoffreichen (Gehalt 1×1018 oder wenigstens 5 x 1017 cm-3) Substraten, kann der Wirkungsgrad dadurch signifikant (∼1%abs Wirkungsgradverlust) reduziert sein. Konkrete Degradationsverluste können je nach verwendeter Architektur der Solarzelle variieren.

Es wurde aber auch gezeigt, dass multikristalline Siliziummaterialien mit typischerweise geringerer Sauerstoff-Kontamination den Effekt zeigen ebenso wie Siliziummaterialien, bei denen Bor nicht den dominanten Dotierstoff darstellt, insbesondere auch Phosphor-dotierte teilkompensierte Materialien mit Bor-Beimischungen.

Bisher sind vor allem vier Ansätze zur Lösung bzw. Umgehung des Problems der Bor-Sauerstoff korrelierten Degradation bekannt.

Ein erster Ansatz setzt bei der Minimierung der unerwünschten Sauerstoffkontamination des Siliziumkristalls an. Zum einen sollen neuartige Beschichtungen des Quarztiegels die Auflösung desselben verhindern. Zum anderen werden vor allem beim Czochralski-Verfahren Magnetfelder eingesetzt, mit denen die Konvektionsbewegung der Siliziumschmelze direkt am Quarztiegel unterdrückt wird, wodurch der Abtrag am Quarztiegel minimiert werden kann. Entsprechend hergestelltes MCz-Silizium weist entsprechend niedrigere Sauerstoffkonzentrationen im Bereich 1×1017 bis 5×1017 cm-3 auf. Der Herstellungsprozess ist aber in der Regel teurer und fehleranfälliger verglichen mit dem normalen Prozess.

Der zweite Ansatz beruht auf der Reduktion der Bor-Konzentration im Ausgangsmaterial. Theoretische Berechnungen zeigen, dass das Wirkungsgradpotential ohne die Einschränkung durch Bor-Sauerstoff korrelierte Defekte bei Dotierungen um 1×1016 cm-3 maximal ist während es bei Beachtung der Bor-Sauerstoff korrelierten Degradation erst bei geringeren Dotierungen maximal wird. Allerdings sinkt das maximale Wirkungsgradpotential mit sinkender Dotierung, sodass geringer dotierte Materialien zwar geringere Degradationsverluste erleiden, dafür aber das maximale Wirkungsgradpotential nicht voll ausgenutzt werden kann. Die optimale Dotierung des Siliziumsubstrats hängt von der konkreten Architektur der Solarzelle ab. Vor allem dieser Ansatz wird derzeit von den meisten Herstellern verfolgt, die Materialien mit Bor-Konzentrationen im Bereich 1×1015 bis 5×1015 cm-3 bei sauerstoffreichem Cz-Silizium verwenden.

Beim dritten Ansatz wird der Dotierstoff Bor durch z.B. Gallium ersetzt. Es konnte gezeigt werden, dass bei der Verwendung von Gallium entweder keine entsprechenden Defekte entstehen oder diese rekombinationsinaktiv sind. Allerdings weist Gallium im Gegensatz zu Bor ein nicht optimales Löslichkeitsverhalten in Kristall und Schmelze auf, wodurch es eine technische Herausforderung darstellt, einen über die Kristallisierungsrichtung homogen dotierten Kristall herzustellen. Ein größerer Materialausschuss und eine höhere Fehleranfälligkeit des Prozesses und somit höhere Kosten sind die Folge. Es ist daher fraglich, ob dieser Ansatz wirtschaftlich tragfähig ist.

Der vierte Ansatz nutzt die Tatsache aus, dass der Bor-Sauerstoff korrelierte Defekt nicht nur in einem inaktiven (siehe Figur 1: Zustand A) und einem aktiven Zustand (siehe Figur 1: Zustand B) vorliegen kann, welche durch Ladungsträgerinjektion, d.h. Degradation, bzw. Erwärmung im Dunkeln, d.h. Anneal, in einander umgewandelt werden können, sondern auch in einem dritten rekombinationsinaktiven "regenerierten" Zustand (siehe Figur 1: Zustand C), der sich, nach aktuellem Kenntnisstand, aus dem aktiven Zustand B durch Regeneration heraus bildet.

Dieser Zustand kennzeichnet sich insbesondere dadurch, dass (a) er schwache oder vernachlässigbare Rekombinationsaktivität besitzt und (b) im Gegensatz zum anfänglich vorliegenden inaktiven Zustand stabil ist unter Beleuchtung bzw. Ladungsträgerinjektion bei Temperaturen <150°C, d.h. es nicht zu einer erneuten Aktivierung der Defekte und damit zur Degradation kommt.

Die Überführung des aktiven Defektes, d.h. des Zustands B, in den inaktiven dritten Zustand C erfordert nach bisherigem Wissen eine Ladungsträgerinjektion z.B. durch Beleuchtung oder den Betrieb der Solarzelle in Durchlassrichtung bei leicht erhöhten Temperaturen im Bereich 50 bis 230°C, wobei höhere Temperaturen oder höhere Überschussladungsträgerdichten die Umwandlung der Defekte beschleunigen. Infolge der Umwandlung der vorhandenen Defekte ergibt sich bei diesem Ansatz keine Einschränkungen bezüglich Sauerstoff- oder Bor-Gehaltes.

Der Prozess zur Überführung der aktiven Defekte (Zustand B) in den beschriebenen dritten "regenerierten" Zustand C wird im Weiteren als "Regeneration" bezeichnet und ist in der DE 10 2006 012 920 B3 ausführlich beschrieben und beansprucht.

Die Wirtschaftlichkeit des Regenerationsprozesses hängt essentiell von der Regenerationsrate bzw. der Zeitdauer ab, die benötigt wird, um eine ausreichend große Zahl an Defekten in den regenerierten, vorteilhaften Zustand C zu bringen. Ein Prozess, der die Regenerationsrate erhöhen und damit die benötige Zeitdauer verringern kann, ist daher von großem wirtschaftlichen Interesse.

Es kann unter anderem als Aufgabe der vorliegenden Erfindung angesehen werden, einen Herstellungsprozess eines Photovoltaikelements anzugeben, sodass der als "Regeneration" bezeichnete Prozess effizienter, d.h. in kürzerer Zeit und mit geringeren Kosten, umgesetzt werden kann und somit das Wirkungsgradpotential von Silizium-basierten Solarzellen besser ausgeschöpft werden kann. Es ist nicht auszuschließen, dass der beschriebene Herstellungsprozess auch auf andere Defekte in Silizium wirkt und mit leichten Adaptionen auch dort Anwendung finden kann.

Gemäß einer Ausführungsform der Erfindung wird ein Verfahren zum Herstellen eines photovoltaischen Elements, z.B. einer gebrauchsfähigen Solarzelle oder -moduls bzw. einer Vorstufe vorgestellt, das die folgenden Schritte umfasst:
Bereitstellen eines z.B. Bor-dotierten oder möglicherweise auch anderweitig dotierten, Sauerstoff-haltigen Siliziumsubstrats und Ausbilden einer Emitterschicht zur Bildung eines pn-Übergangs an der Oberfläche des Siliziumsubstrats. Hierbei wird
(a) Wasserstoff in das Siliziumsubstrat eingebracht,
(b) das Substrat, wenn im konkreten Prozess erforderlich, nur kurz eine Temperatur von >450°C erfahren, wenn während dieser Phase kein neuer Wasserstoff in das Siliziumsubstrat eingebracht wird,
(c) das Substrat eventuell im Temperaturbereich 230-450°C für eine gewisse Zeitdauer gehalten und eventuell während dieser Phase Überschussminoritätsladungsträger im Substrat erzeugt werden und anschließend gegebenenfalls
(d) das Substrat im Temperaturbereich von 50-230°C gehalten und während dieser Phase Überschussminoritätsladungsträger erzeugt.

Der Prozessschritt (d) entspricht hierbei gerade dem Verfahren nach DE 10 2006 012 920 B3.

Das vorgestellte Verfahren mit den Teilschritten (a) bis (c) zielt unter anderem darauf ab, ein photovoltaisches Element derart zu verändern, dass der in DE 10 2006 012 920 B3 beschriebene Prozess optimiert und damit wirtschaftlich attraktiv ablaufen kann.

Das bei dem erfindungsgemäßen Verfahren verwendete Siliziumsubstrat kann ein Wafer sein, der nach dem Czochralski-Verfahren hergestellt wurde und eine Bor-Dotierung im Bereich von 1×1015 bis 1×1017 cm-3 aufweist. Ein solcher Wafer weist herstellungsbedingt eine gewisse Sauerstoffkonzentration von beispielsweise 1×1017 bis 3×1018 cm-3 auf. Es können jedoch auch andere Bor-dotierte, Sauerstoff-haltige Siliziumsubstrate verwendet werden, wie z.B. multikristalline Siliziumwafer oder Siliziumschichten, die aus der gasförmigen oder flüssigen Phase auf einem Träger abgeschieden wurden.

Um das Potentialgefälle (pn-Übergang), welches zur Trennung von Elektron-Loch Paaren benötigt wird, zu bewirken, wird erfindungsgemäß an der Oberfläche des Siliziumsubstrats ein Emitter ausgebildet. Dabei handelt es sich um einen Bereich, der in der Regel einen zu dem Halbleitertyp des Substrates entgegengesetzten Halbleitertyp aufweist. Ist Bor der dominante Dotierstoff im Substrat, so ist das Substrat p-dotiert. Es ist nicht auszuschließen, dass der Halbleitertyp des Substrats trotz Bor-Dotierung n-Typ ist, wenn entsprechende Mengen n-dotierender Stoffe, wie Phosphor, vorhanden sind. Das Ausbilden des Emitters kann beispielsweise durch ein oberflächliches Eindiffundieren von Dotierstoffen wie Phosphor (bei p-Typ Substrat) oder Bor (bei n-Typ Substrat) erfolgen. Eine solche Diffusion wird typischerweise bei Temperaturen oberhalb von 800°C durchgeführt. Es können aber auch andere Verfahren verwendet werden, um eine entsprechende Emitterschicht zu erzeugen. Beispielsweise kann eine Emitterschicht entsprechender Polarität aus einer gasförmigen oder flüssigen Phase oder einem Plasma an der Substratoberfläche abgeschieden werden. Eine weitere Möglichkeit zur Erzeugung einer Emitterschicht kann die Einlegierung entsprechender Stoffe sein. Ferner muss die Oberfläche des Siliziumsubstrats nicht vollständig bedeckt sein. Es kann genügen, dass lediglich Teilbereich der Oberfläche an Vorder- und/oder Rückseite mit einer Emitterschicht bedeckt sind.

Auch der Fall, in dem der Emitter und das Substrat vom gleichen Halbleitertyp sind, ist realisierbar, z.B. wenn das Substrat und die Emitterschicht eine stark unterschiedliche Bandstruktur aufweisen (Hetero-Strukturen), so dass sich an der Schnittstelle eine Bandverbiegung einstellt, die das gewünschte Potentialgefälle bewirkt. Im Grenzfall muss hierfür nicht einmal ein Halbleiter verwendet werden, da auch ein entsprechend gewähltes Metall zu einer solchen Bandverbiegung führen kann (MIS Strukturen).

Die Einbringung von Wasserstoff in das Siliziumsubstrat ist im Rahmen des erfindungsgemäßen Verfahrens zwingend erforderlich, da ein Siliziumkristall typischerweise keine signifikanten Mengen an Wasserstoff beinhaltet.

Wasserstoff kann mit verschiedensten Verfahren eingebracht werden. Beispielsweise kann der Wasserstoff im Rahmen eines Temperaturschrittes aus ein- oder beidseitig aufgebrachten Beschichtungen wie hydrogenierten Siliziumnitriden (a-SiNx:H), hydrogenierten Siliziumcarbiden (a-SiCx:H), hydrogenierten Siliziumoxiden (a-SiOx:H), hydrogenierten Siliziumoxynitriden (a-SiOxNy:H), hydrogenierten Aluminiumoxiden (Al2O3), hydrogenierten amorphem Silizium (a-Si:H) oder vergleichbaren Schichten, die auch andere Funktionen haben können (z.B. Passivierung der Oberfläche, Antireflexionsbeschichtung), freigesetzt werden und in den Siliziumkristall eindringen. Die exakten Parameter, insbesondere was Temperaturen betrifft, bei denen es zu einer Freisetzung des in der Schicht gebundenen Wasserstoffs kommt, variieren von Schicht zu Schicht und werden in verschiedenen Ausführungsformen beschrieben. Entsprechende analoge Ausführungsformen für vergleichbare Schichten erschließen sich dem Fachmann.

Es sei an dieser Stelle noch erwähnt, dass die Herstellung der metallischen Kontakte einen Hochtemperaturschritt erfordern kann, der auch zur Freisetzung von Wasserstoff aus hydrogenierten Beschichtungen führen kann.

Gemäß einer Ausführungsform wird hydrogeniertes Siliziumnitrid (a-SiNx:H) als Wasserstoffquelle eingesetzt, welches sich während eines Hochtemperaturschrittes bei Temperaturen oberhalb 600°C umstrukturiert und Wasserstoff in atomarer und molekularer Form freisetzt, der in das Siliziumsubstrat eindringen kann. Die Menge des freigesetzten Wasserstoffs kann dabei abhängen von
(a) der Zusammensetzung der Schicht vor dem Hochtemperaturschritt,
(b) der Maximaltemperatur,
(c) dem Temperaturverlauf, insbesondere der Dauer des Hochtemperaturschrittes.
Im Allgemeinen wird bei höheren Temperaturen mehr Wasserstoff mit einer höheren Rate freigesetzt. Des Weiteren ist es zweckdienlich, wenn sich der Wasserstoff im gesamten Substrat verteilt und insbesondere auch tief in das Substrat eindringt.

Die Temperaturführung während des Hochtemperaturschrittes ist so zu wählen, dass
(I) Temperaturen oberhalb von 600°C erreicht werden, die zu einer Freisetzung von Wasserstoff führen,
(II) die Temperaturführung und Dauer derart gestaltet ist, dass eine ausreichende Menge an Wasserstoff in das Substrat eindiffundiert und
(III) eine Verteilung des Wasserstoffs im Substrat gewährleistet ist.

Beispielsweise kann dies realisiert werden im Rahmen eines Legierungsprozesses der metallischen Kontakte einer Solarzelle, bei dem Temperaturen >750°C für wenige Sekunden vorliegen.

Die Argumentation mit ähnlichen Schichten, die im Rahmen eines Hochtemperaturschrittes Wasserstoff freisetzen, wie beispielsweise hydrogenierten Siliziumcarbiden, hydrogenierten Siliziumoxiden oder hydrogenierten Siliziumoxynitriden, ist analog. Dem Fachmann erschließen sich sinngemäße entsprechende Anpassungen der Temperaturführung.

Gemäß einer weiteren Ausführungsform wird hydrogeniertes Aluminiumoxid (Al2O3) als Wasserstoffquelle verwendet, das im Rahmen eines Temperaturschrittes bei Temperaturen >250°C Wasserstoff freisetzen kann, welcher ins Substrat eindringen kann. Analog zum weiter oben diskutierten Fall von Siliziumnitridschichten, sind auch hier die Maximaltemperatur, Temperaturverlauf und Dauer entsprechend zu wählen, um eine ausreichende hohe und gut verteilte Wasserstoffkonzentration im Substrat zu erreichen. Um die Verteilung des Wasserstoffs im Substrat zu unterstützen, können im Substrat während des Temperaturschrittes Überschussminoritätsladungsträger generiert werden. Dies kann beispielsweise durch Beleuchtung oder beispielsweise durch das Einleiten eines externen Stromes geschehen.

Gemäß einer weiteren Ausführungsform wird hydrogeniertes amorphes Silizium (a-Si:H) als Wasserstoffquelle verwendet, wobei im Rahmen eines Temperaturschrittes bei Temperaturen >100°C Wasserstoff freigesetzt wird. Analog zu den weiter oben diskutierten Fällen von z.B. Siliziumnitridschichten und Aluminiumoxiden sind auch hier die Maximaltemperatur, Temperaturverlauf und Dauer entsprechend zu wählen, um eine ausreichende hohe und gut verteilte Wasserstoffkonzentration im Substrat zu erreichen. Um die Verteilung des Wasserstoffs im Substrat zu unterstützen, können im Substrat während des Temperaturschrittes Überschussminoritätsladungsträger generiert werden. Dies kann beispielsweise durch Beleuchtung oder beispielsweise durch das Einleiten eines externen Stromes geschehen.

Gemäß einer weiteren Ausführungsform können auch Mehrschichtsysteme beispielsweise aus oben genannten Schichten verwendet werden. Beispielsweise kann das Schichtsystem derart gestaltet sein, dass die am Substrat anliegende Schicht als Wasserstoffquelle dient und sich zumindest eine weitere Schicht darauf befindet.

Zumindest eine der weiteren Schichten kann dabei als Wasserstoffdiffusionsbarriere wirken, d.h. dass diese weitere Schicht für Wasserstoff weniger durchlässig ist als die darunter liegende wasserstoffhaltige Schicht und somit die Wasserstoffdiffusion durch diese Schicht im Rahmen eines Hochtemperaturschrittes nur vergleichsweise langsam abläuft. In diesem Fall dient diese Schicht als Wasserstoff-Reflektor und der aus der Wasserstoffquelle freigesetzte Wasserstoff wird besser im Substrat gehalten. Dies ist vorteilhaft, weil die Ausbeute an Wasserstoff aus der Quellschicht, d.h. das Verhältnis aus ins Substrat diffundierter Wasserstoffmenge zu freigesetzter Menge, in diesem Fall besser ist und, wie später angeführt, auch die Ausdiffusion bei tieferen Temperaturen minimiert wird.

Es ist prinzipiell auch denkbar, eine anderweitige Schicht zwischen Quellschicht und Substrat zu platzieren, die keinen Einfluss auf die Diffusion des Wasserstoffs von der Quellschicht ins Substrat hat. Eine Barriereschicht für Wasserstoff ist an der gleichen Stelle in speziellen Fällen ebenfalls denkbar.

Die Einbringung von Wasserstoff in das Substrat kann auch auf andere Weise erfolgen. Beispielsweise kann der Wasserstoff in das Siliziumsubstrat implantiert werden, d.h. es werden Protonen entsprechend beschleunigt und auf bzw. in das Substrat geschossen. Abhängig von der Wahl der Prozessparameter, insbesondere der Energie der Protonen als auch ihrer Dosis, kann eine Wasserstoffverteilung im Substrat gezielt erzeugt werden. An die eigentliche Ionenimplantation kann sich ein Hochtemperaturschritt >500 °C anschließen, der einerseits entstandene Kristallschädigungen, die bei der Abbremsung der Protonen auftreten können, ausheilen soll und andererseits noch eine Umverteilung des Wasserstoffs bewirken kann.

Die Einbringung des Wasserstoffs in das Substrat kann darüber hinaus auch beispielsweise durch eine Eindiffusion atomaren Wasserstoffs aus einer mit Wasserstoff angereicherten Atmosphäre oder in einem Wasserstoff-haltigen Plasma erfolgen.

Darüber hinaus sind andere Verfahren zur Einbringung des Wasserstoffs in das Siliziumsubstrat denkbar, auch wenn sie hier nicht explizit angeführt werden.

Im Rahmen des erfindungsgemäßen Verfahrens ist weiterhin anzustreben, dass der eingebrachte Wasserstoff in ausreichender Menge im Substrat verbleibt. Dazu sollte vermieden werden, dass sich das Substrat auf Temperaturen >400°C, insbesondere > 450°C, für längere Dauer befindet, sofern kein neuer Wasserstoff aus oben genannten oder anderen Quellen zur Verfügung steht, da ansonsten Wasserstoffeffusion in signifikantem Maße auftritt.

Insbesondere für den Fall, dass die Wasserstoffeinbringung höhere Temperaturen erfordert, beispielsweise bei der Freisetzung des Wasserstoffs aus hydrogenierten Schichten wie z.B. Siliziumnitriden, sollte die Zeitdauer in dem Temperaturbereich minimiert werden, in dem die Schicht weniger Wasserstoff in das Substrat abgibt, als aus dem Substrat effundiert.

Desweiteren kann es nachteilig sein, bei Temperaturen oberhalb 400°C, insbesondere oberhalb 450°C, Überschussminoritätsladungsträger zu generieren, da dies den Wasserstoff in einen mobileren Ladungszustand versetzen kann und somit seine Effusion unterstützen kann.

Gemäß der Ausführungsform mit hydrogenierten Siliziumnitridschichten (a-SiNx:H) als Wasserstoffquelle ist es beispielsweise angezeigt, den Temperaturbereich zwischen 400°C bzw. 450°C und 600-650°C zu meiden und die Substrattemperatur in kurzer Zeit von Temperaturen oberhalb 650°C auf eine Temperatur unterhalb 450°C abzusenken, wobei eine Abkühlrate insbesondere oberhalb 550°C größer 3 K/s, besser größer 30 K/s angezeigt ist.

In diesem Punkt kann die Ausführungsform mit mindestens einer Diffusionsbarrierenschicht für Wasserstoff, wie bereits beschrieben, besonders vorteilhaft sein, da der Wasserstoff selbst im fraglichen Temperaturbereich >400°C bzw. > 450°C an der Effusion aus dem Substrat gehindert wird. In diesem Fall können auch geringere Abkühlraten größer 0,3 K/s noch akzeptabel sein.

Im Rahmen des erfindungsgemäßen Verfahrens kann es vorteilhaft sein, das Substrat im Temperaturbereich 230-450°C für eine gewisse Zeitdauer von wenigstens 10 s, maximal 30 min, zu halten. Dies kann beispielsweise in Form eines Plateaus oder beispielsweise in Form einer Temperaturrampe realisiert sein.

Es wurde festgestellt, dass der durch das erfindungsgemäße Verfahren zu erreichende gewünschte Effekt einer Steigerung der Regenerationsrate mit steigenden Substrattemperaturen innerhalb einer kürzeren Behandlungsdauer erreicht werden kann. Für den angestrebten Effekt der Steigerung der Regenerationsrate ist es weiterhin prinzipiell nicht notwendig, Überschussminoritätsladungsträger im Substrat zu generieren. Wie später angeführt, kann es trotzdem vorteilhaft sein, Überschussminoritätsladungsträger im Substrat zu generieren, auch um die Diffusion von Wasserstoff im genannten Temperaturbereich durch eine Manipulation des Ladungszustandes zu beeinflussen.

Gemäß einer Ausführungsform wird das Substrat ohne Generation von Überschussminoritätsladungsträgern auf einer Temperatur im Bereich von 230 bis 450°C gehalten werden, wobei höhere Temperaturen die notwendige Haltedauer reduzieren, bis der gewünschte Effekt erreicht wurde. Anschließend wird das Substrat mit einer steilen Temperaturrampe auf Raumtemperatur herunter gekühlt werden. Das Substrat kann danach dem Regenerationsprozess wie in der DE 10 2006 012 920 B3 beschrieben zugeführt werden.

Gemäß einer anderen Ausführungsform wird das Substrat ohne Generation von Überschussminoritätsladungsträgern auf einer Temperatur im Bereich von 230 bis 450°C gehalten werden, wobei höhere Temperaturen die notwendige Haltedauer reduzieren, bis der gewünschte Effekt erreicht wurde. Direkt im Anschluss wird das Substrat in den Temperaturbereich von 50 bis 230°C überführt, in dem der Regenerationsprozess analog wie in der DE 10 2006 012 920 B3 beschrieben ablaufen kann.

Gemäß einer anderen Ausführungsform wird das Substrat mit Generation von Überschussminoritätsladungsträgern, beispielsweise durch Beleuchtung, auf einer Temperatur im Bereich von 230..450°C gehalten werden, wobei höhere Temperaturen die notwendige Haltedauer reduzieren, bis der gewünschte Effekt erreicht wurde. Neben einer Steigerung der Regenerationsrate kann es unter bestimmten Umständen zu einer teilweisen oder vollständigen Regeneration auch bei Temperaturen >230°C kommen. Direkt im Anschluss wird das Substrat in den Temperaturbereich von 50 bis 230°C überführt, in dem der Regenerationsprozess bei Bedarf weiter abläuft, der aufgrund der teilweise bereits abgelaufenen Regeneration beschleunigt ablaufen kann.

Im Folgenden soll beispielhaft eine vollständige Ausführungsform eines erfindungsgemäßen Verfahrens illustriert werden. In dieser Ausführungsform wird hydrogeniertes Siliziumnitrid als Wasserstoffquelle verwendet, wobei die Schicht nur einseitig auf einem Siliziumwafer aufgebracht wurde, während die gegenüberliegende Seite ganzflächig von Aluminium bedeckt ist. Auf der Siliziumnitridschicht, die auch als Antireflexionsbeschichtung und Passivierungsschicht fungiert, befindet sich eine beispielsweise mittels Siebdruck lokal aufgebrachte metallische Paste, die bei hohen Temperaturen die Siliziumnitridschicht angreift und somit den Kontakt zum darunter liegenden Silizium herstellt. Die Freisetzung des Wasserstoffs aus der Siliziumnitridschicht erfolgt im Rahmen eines typischen Legierungsprozesses der Metallisierung des photovoltaischen Elements, die typischerweise oberhalb 750°C in einem Gürtelofen erfolgt.

In Fig. 2 ist eine Vorrichtung in Form eines speziell ausgestalteten Durchlaufofens 10 dargestellt, die zum Behandeln eines Siliziumsubstrats im Rahmen einer Herstellung einer Solarzelle eingesetzt werden kann und die dazu ausgebildet ist, eine Ausführungsform des hierin beschriebenen Herstellungsverfahrens und insbesondere des dabei durchzuführenden Stabilisierungsbehandlungsschritts auszuführen.

Der Durchlaufofen 10 weist einen von angetriebenen Rollen 12 bewegbaren Gürtel 14 auf. An einer Einlassseite 16 können Siliziumsubstrate auf den Gürtel 14 gelegt werden und dann mittels des Gürtels 14 durch verschieden beheizte Zonen des Durchlaufofens 10 gefahren werden. Die Siliziumsubstrate können zuvor an ihrer Oberfläche mit einer wasserstoffhaltigen Schicht versehen worden sein. Ergänzend kann auf diese wasserstoffhaltige Schicht ein Muster aus metallhaltiger Paste aufgedruckt worden sein, wodurch letztendlich die Metallkontakte für die Solarzelle gebildet werden sollen.

In einer Vorheizzone 18 sind ein oder mehrere Heizstrahler 20 angeordnet, mit deren Hilfe die auf dem Gürtel 14 transportierten Siliziumsubstrate auf Temperaturen bis zu oberhalb von 500°C vorgeheizt werden können.

In einer sich daran anschließenden Maximalheizzone 22 ist wenigsten ein weiterer Heizstrahler 24 vorgesehen, mit dessen Hilfe durchlaufende Siliziumsubstrate kurzzeitig auf Temperaturen bis zu oberhalb von 700°C erhitzt werden können.

Hieran schließt sich eine Abkühlzone 26 an. In dieser Abkühlzone 26 ist nicht nur vorzugsweise kein Heizstrahler vorgesehen, sondern es ist sogar eine Kühlvorrichtung 28 vorgesehen, mithilfe derer die durchlaufenden Siliziumsubstrate aktiv gekühlt werden können. Die Kühlvorrichtung kann beispielsweise als Gebläse zum Einblasen von kühlem Stickstoffgas in die Kühlzone 26 ausgebildet sein.

Hiernach kann sich eine Temperaturhaltezone 30 anschließen. In dieser Temperaturhaltezone 30 ist ein weiterer Heizstrahler 32 vorgesehen, mithilfe dessen die Temperatur der Siliziumsubstrate innerhalb der Temperaturhaltezone 30 in einem Bereich von 230°C bis 450°C gehalten werden kann. Eine Länge der Temperaturhaltezone 30 kann dabei derart bemessen sein, dass bei einer gegebenen Durchlaufgeschwindigkeit ein von dem Gürtel 14 transportiertes Siliziumsubstrat wenigstens etwa 10s benötigt, um durch die Temperaturhaltezone 30 hindurch transportiert zu werden, wobei es mithilfe des Heizstrahlers 32 auf einer gewünschten Temperatur innerhalb des Temperaturbereichs von 230 bis 450°C gehalten wird. Insbesondere kann die Temperaturhaltezone 30 beispielsweise wenigstens gleich lang, vorzugsweise wenigstens drei Mal, vorzugsweise wenigstens sechs Mal länger sein als die Maximalheizzone 22. Der gesamte Durchlaufofen kann beispielsweise mehr als doppelt so lange sein wie ein herkömmlicher Durchlaufofen ohne eine Temperarturhaltezone 30.

Anschließend erreicht das Siliziumsubstrat eine Auskühlzone 34, in der es weiter abkühlen kann. In der Auskühlzone 34 kann eine starke Lichtquelle 36, beispielsweise in Form eines Lasers mit aufgeweitetem Laserstrahl oder in Form einer starken Lampe mit Wellenlängen, die vom Siliziumsubstrat absorbiert werden können, vorgesehen sein, um die durchlaufenden Siliziumsubstrate mit Belichtungsintensitäten von wenigstens 0,3 kW/m2 zu beleuchten. Da die Siliziumsubstrate zumindest am Anfang der Auskühlzone 34 noch auf einer Temperatur deutlich über 90°C sind, kann hierdurch der Regenerationsprozess bewirkt werden und die letztendlich hergestellten Solarzellen in ihrem Wirkungsgrad stabilisiert werden.

Alternativ oder ergänzend kann auch in der Temperaturhaltezone 30 eine Lichtquelle vorgesehen werden (bei der in Fig. 2 dargestellten Ausgestaltung nicht vorgesehen). Durch geeignetes Beleuchten der Siliziumsubstrate bereits in der Temperaturhaltezone 30 kann eventuell unterstützt werden, dass in die Siliziumsubstrate eingedrungener Wasserstoff einen für eine nachfolgende Regeneration vorteilhaften Zustand einnimmt. Andererseits kann durch geeignetes Beleuchten bereits innerhalb der Temperaturhaltezone 30 bereits eine Regeneration innerhalb der Siliziumsubstrate zumindest teilweise oder bei geeigneter Prozessführung gegebenenfalls auch vollständig durchgeführt werden.

Alle beschriebenen Komponenten des Durchlaufofens 10 können vorzugsweise von einer gemeinsamen Steuerung 40 gesteuert werden.

Nachdem die Siliziumsubstrate den gesamten Durchlaufofen 10 durchlaufen haben, können sie an einer Auslassseite 38 entnommen und weiteren Prozessierungs- oder Charakterisierungsschritten unterzogen werden.

In Figur 3 ist exemplarisch eine Temperaturführung beim Durchlauf des Wafers durch verschiedene Zonen des Gürtelofens 10 gezeigt.

Beim Eintritt in den Gürtelofen und Durchlauf durch die Vorheizzone 18 (Zone 1) wird der als Siliziumsubstrat dienende Wafer zunächst erwärmt bis bei etwa 650°C die Wasserstofffreisetzung aus der zuvor darauf abgeschiedenen hydrogenierten Siliziumnitridschicht und die Eindiffusion in den Wafer beginnt (Zone 2). Nach Erreichen der Maximaltemperatur in der Maximalheizzone 22 nimmt die Freisetzung von Wasserstoff aus der Siliziumnitridschicht wieder ab. Gleichzeitig effundiert bereits ein Teil des in den Wafers eindiffundierten Wasserstoffs bereits wieder. Fällt die Temperatur unter etwa 650°C, so überwiegt die Effusion aus dem Wafer die Freisetzung von Wasserstoff aus der Siliziumnitridschicht bzw. die Eindiffusion in den Wafer und der Wasserstoffgehalt des Wafers nimmt wieder ab. Um dies möglichst weitgehend zu verhindern wird der Wafer in der Abkühlzone 26 (Zone 3) mit einer steilen Temperaturrampe mit einer hohen Abkühlrate von z.B. mehr als 20 K/s herunter gekühlt und eine weitere Effusion des Wasserstoffs unterdrückt. Direkt im Anschluss in der Temperaturhaltezone 30 (Zone 4) daran wird der Wafer im Temperaturbereich von 230 bis 450°C gehalten und entsprechend des beschriebenen Verfahrens setzt der Prozess ein, der die Regenerationsrate, die sich in einem späteren Regenerationsprozessschritt zeigt, erhöht. Die später benötigte Regenerationszeit kann noch durch eine Generation von Überschussladungsträgern beispielsweise durch Beleuchtung in Zone 4 verkürzt werden. Dies ist nicht zwingend erforderlich, ist aber der Wirtschaftlichkeit eines Gesamtprozesses bestehend aus dem hier beschriebenen Verfahren und dem eventuell bereits inkludierten oder separat durchzuführenden Verfahrenen nach DE 10 2006 012 920 B3 zuträglich. In Zone 5 kann sich das Regenerationsverfahren analog DE 10 2006 012 920 B3 direkt anschließen. Wahlweise kann dies aber auch getrennt erfolgen.

In Figur 3 ist ergänzend als gestrichelte Linie 42 auch ein typischer Temperaturverlauf bei Durchlaufen eines herkömmlichen Durchlaufofens, wie er beispielsweise konventionell zum Einfeuern von Siebdruckkontakten verwendet wird, dargestellt. Es ist zu erkennen, dass die Siliziumsubstrate nach Erreichen einer Maximaltemperatur kontinuierlich und näherungsweise linear abkühlen. Dabei ist eine Verweildauer innerhalb des Temperaturbereichs von oberhalb 450°C deutlich länger als bei dem erfindungsgemäßen Durchlaufofen, wohingegen eine Verweildauer innerhalb des Temperaturbereichs von zwischen 230°C und 450°C deutlich kürzer ist als bei dem erfindungsgemäßen Durchlaufofen.

Weitere Einzelheiten, Merkmale und Vorteile von Ausführungsformen der Erfindung erschließen sich dem Fachmann auch aus der nachfolgenden Beschreibung eines zu Grunde liegenden Modells.

Im Folgenden soll ein Modell vorgestellt werden, mit dem die Verkürzung der Zeitkonstanten des Regenerationsprozesses erklärt werden könnte. Es wird darauf hingewiesen, dass die genauen kausalen Zusammenhänge, die zu der bei dem erfindungsgemäßen Verfahren beobachteten Erhöhung der Regenerationsraten und damit zu einer effizienteren Umsetzung des Regenerationsprozesses führen, zum Zeitpunkt der Ausarbeitung der vorliegenden Patentanmeldung noch nicht im Einzelnen verstanden waren. Das vorgestellte Modell soll daher den Schutzumfang, wie er durch die beigefügten Ansprüche definiert ist, in keiner Weise beschränken.

Die Erfinder gehen davon aus, dass Wasserstoff, insbesondere dessen Menge, dessen Bindungszustand und Ladungszustand im Siliziumkristall, einen entscheidenden Einfluss auf die Umwandlung der rekombinationsaktiven Defekte in den dritten, regenerierten Zustand hat (Zustand C), beispielsweise durch Anlagerung des Wasserstoffs an den Defekt. Da sich direkt nach dem Kristallwachstum in der Regel kein oder zu wenig Wasserstoff im Siliziumkristall befindet, muss zunächst Wasserstoff in den Kristall eingebracht werden, um eine Umwandlung in den regenerierten Zustand zu ermöglichen. Prinzipiell kommen verschiedene Wasserstoff-Quellen in Frage, wie sie weiter oben beschrieben wurden.

Letztendlich gehen die Erfinder davon aus, dass die Herkunft des Wasserstoffs von untergeordneter Bedeutung im Rahmen dieses Modells ist, solange eine ausreichend große Konzentration im Kristall des Siliziumsubstrats im Temperaturbereich unter etwa 450°C vorliegt und eine ausreichend homogene Verteilung lateral als auch in der Tiefe vorliegt. Oberhalb von etwa 400 oder etwa 450°C kann Wasserstoff noch in signifikantem Maße aus dem Siliziumkristall in die Umgebung entweichen. Der beschriebene erfindungsgemäße Herstellungsprozess berücksichtigt dies dadurch, dass sich die im Herstellungsprozess befindliche Solarzelle möglichst kurz nur in einem Temperaturbereich >400 bzw. >450°C befindet, in dem der Wasserstoff ausdiffundiert, jedoch nicht neuer Wasserstoff z.B. aus einer Schicht nachgeliefert wird.

Untersuchungen der Erfinder lassen es darüber hinaus plausibel erscheinen, dass der Bindungszustand bzw. Ladungszustand des Wasserstoffs von entscheidender Bedeutung ist. Demnach könnte der Wasserstoff im Temperaturbereich unter etwa 500°C größtenteils in mindestens zwei verschiedenen Bindungszuständen vorliegen, beispielsweise in Form von H2 Molekülen oder an Bor-Atome als B-H Paare gebunden. Allerdings wäre Wasserstoff in solch gebundener Form nicht ausreichend mobil. Die Regeneration würde in dieser Beschreibung einer Ablösung des Wasserstoffs, der nachfolgenden Diffusion in atomarer Form und der Anlagerung an einen Bor-Sauerstoff korrelierten Defekt entsprechen. Die Regenerationsrate, also die Konversionsrate von Defekten im degradierten Zustand (Zustand B) in den regenerierten Zustand (Zustand C) und damit auch die Zeitdauer, die benötigt wird, damit der Regenerationsprozess ablaufen kann, hängt in diesem Modell unter anderem davon ab, wie leicht sich der Wasserstoff aus seinem gebundenen Zustand befreien kann, entweder rein thermisch gestützt oder auch durch eine Veränderung des Ladungszustandes. Der beschriebene erfindungsgemäße Herstellungsprozess kann eventuell dafür sorgen, dass sich Wasserstoff in ausreichender Menge in dem (zumindest unter Ladungsträgerinjektion) nur leicht gebundenen Zustand befindet und damit für den Regenerationsprozess zur Verfügung steht. Des Weiteren ist die Mobilität des atomaren Wasserstoffs nach dessen Abspaltung abhängig von seinem Ladungszustand. In p-Typ Silizium liegt der Wasserstoff in der Regel positiv geladen vor und seine Diffusion wird durch elektrostatische Wechselwirkung im Kristallgitter behindert. Liegt der Wasserstoff hingegen in neutralem Ladungszustand vor, so ist seine Mobilität signifikant höher. Untersuchungen zeigen, dass sich der Ladungszustand durch Ladungsträgerinjektion (Beleuchtung oder durch Einleiten eines Stroms) manipulieren lässt. Somit kann mittels Ladungsträgerinjektion die Beweglichkeit des Wasserstoffs derart beeinflusst werden, dass er aufgrund der höheren Mobilität schneller zu Defekten im Siliziumkristall gelangt und diese auch aufgrund seines Ladungszustandes passivieren kann.

Abschließend wird darauf hingewiesen, dass die Begriffe "umfassen", "aufweisen" etc. das Vorhandensein weiterer zusätzlicher Elemente nicht ausschließen sollen. Der Begriff "ein" schließt auch das Vorhandensein einer Mehrzahl von Elementen bzw. Gegenständen nicht aus. Ferner können zusätzlich zu den in den Ansprüchen genannten Verfahrensschritten weitere Verfahrensschritte nötig oder vorteilhaft sein, um z.B. eine Solarzelle endgültig fertig zu stellen. Die Bezugszeichen in den Ansprüchen dienen lediglich der besseren Lesbarkeit und sollen den Schutzbereich der Ansprüche in keiner Weise einschränken.

### BEZUGSZEICHENLISTE

- A: annealter, inaktiver Zustand
- B: degradierter, aktiver Zustand
- C: regenerierter, inaktiver Zustand
- (1)-(5): Heizzonen
- 10: Durchlaufofen
- 12: angetriebene Rollen
- 14: Gürtel
- 16: Einlassseite
- 18: Vorheizzone
- 20: Heizstrahler
- 22: Maximalheizzone
- 24: Heizstrahler
- 26: Abkühlzone
- 28: Kühlvorrichtung
- 30: Temperaturhaltezone
- 32: Heizstrahler
- 34: Auskühlzone
- 36: Lichtquelle
- 38: Auslassseite
- 40: Steuerung
- 42: Temperaturkurve in herkömmlichem Durchlaufofen

## Patentansprüche

1. Verfahren zum Herstellen eines Photovoltaikelements mit stabilisiertem Wirkungsgrad, aufweisend die folgenden Schritte:
Bereitstellen eines Siliziumsubstrats;
Ausbilden einer Emitterschicht an einer Oberfläche des Siliziumsubstrats;
Ausbilden elektrischer Kontakte an dem Siliziumsubstrat;
**dadurch gekennzeichnet, dass** das Verfahren ferner einen
Stabilisierungsbehandlungsschritt aufweist, aufweisend:
Einbringen von Wasserstoff in das Siliziumsubstrat, wobei der Wasserstoff bei Temperaturen oberhalb von 650°C, eingebracht wird und eine anschließende Abkühlung bis auf 450°C mit einer Rampe mit einer Abkühlrate oberhalb 550°C von mindestens 10 K/s durchgeführt wird; und anschließend
Erzeugen von Überschussminoritätsladungsträgern in dem Siliziumsubstrat, während das Siliziumsubstrat auf einer Temperatur von über 230°C ist.

2. Verfahren nach Anspruch 1, wobei der Stabilisierungsbehandlungsschritt ferner einen Schritt eines Haltens des Siliziumsubstrats innerhalb eines Temperaturbereichs von zwischen 230°C und 450°C für eine Zeitdauer von wenigstens 10s, vorzugsweise wenigstens 30s, nachdem Wasserstoff in das Siliziumsubstrat eingebracht wurde, umfasst.

3. Verfahren nach Anspruch 2, wobei die Überschussminoritätsladungsträger in einem anschließenden Verfahrensschritt nach dem Halten des Siliziumsubstrats innerhalb des Temperaturbereichs von zwischen 230°C und 450°C erzeugt werden.

4. Verfahren nach Anspruch 2, wobei die Überschussminoritätsladungsträger in einem gemeinsamen Verfahrensschritt zusammen mit dem Halten des Siliziumsubstrats innerhalb des Temperaturbereichs von zwischen 230°C und 450°C erzeugt werden.

5. Verfahren nach einem der Ansprüche 1 bis 4, wobei die anschließende Abkühlung bis auf 450°C mit einer Rampe mit einer Abkühlrate oberhalb 550°C von mindestens 20 K/s, stärker bevorzugt mindestens 30 K/s, noch stärker bevorzugt mindestens 60 K/s durchgeführt wird.

6. Verfahren nach einem der Ansprüche 1 bis 5, wobei die Überschussminoritätsladungsträger durch Beleuchten mit einer Beleuchtungsintensität größer 0,3 kW/m², vorzugsweise größer 1 kW/m², stärker bevorzugt größer 3 kW/m² mit Licht mit Wellenlängen kleiner als 1180 nm erzeugt werden.

7. Verfahren nach einem der Ansprüche 1 bis 6, wobei die Überschussminoritätsladungsträger bei einer Temperatur des Siliziumsubstrates von zwischen 230°C und 450°C, vorzugsweise zwischen 230°C und 400°C, stärker bevorzugt zwischen 230°C und 350°C und noch stärker bevorzugt zwischen 230°C und 300°C erzeugt werden.

8. Verfahren nach einem der Ansprüche 1 bis 7, ferner aufweisend ein Abscheiden einer wasserstoffhaltigen Schicht auf mindestens eine Oberfläche des Siliziumsubstrats, welche bei dem Einbringen von Wasserstoff in das Siliziumsubstrat als Wasserstoffquelle dient.

9. Verfahren nach Anspruch 8, wobei die wasserstoffhaltige Schicht eine hydrogenierte Siliziumnitridschicht ist.

10. Verfahren nach Anspruch 8 oder 9, wobei die wasserstoffhaltige Schicht mit mindestens einer Schicht bedeckt ist, die weniger durchlässig für Wasserstoff ist als die wasserstoffhaltige Schicht.

11. Verfahren nach einem der Ansprüche 1 bis 10, wobei das Siliziumsubstrat mit einer wasserstoffhaltigen Schicht beschichtet wird und das Siliziumsubstrat anschließend in einem Durchlaufofen durch geeignet temperierte Zonen gefahren wird.

12. Vorrichtung zum Behandeln eines Siliziumsubstrats im Rahmen einer Herstellung eines Photovoltaikelements, wobei die Vorrichtung als Durchlaufofen (10) dazu ausgebildet ist, den Stabilisierungsbehandlungsschritt eines Verfahrens gemäß einem der Ansprüche 1 bis 11 durchzuführen, wobei die Vorrichtung mit einer Mehrzahl unterschiedlich temperierbarer Zonen (1, 2, 3, 4, 5; 18, 22, 26, 30, 34) ausgebildet ist und eine Beleuchtungseinrichtung (36) aufweist, wobei die Zonen derart temperierbar sind und die Vorrichtung einschließlich der Beleuchtungseinrichtung derart ausgebildet ist, dass ein den Durchlaufofen durchlaufendes Siliziumsubstrat in einer Maximalheizzone (22) zunächst kurzzeitig auf eine Temperatur von oberhalb 650°C erhitzt wird, dann in einer Abkühlzone (26) mit einer Abkühlrate oberhalb 550°C von mindestens 10 K/s auf eine Temperatur unterhalb von 450°C abgekühlt wird und dann in einer Temperaturhaltezone (30) bei einer Temperatur von zwischen 230°C und 450°C gehalten und gleichzeitig oder nachfolgend das Siliziumsubstrat bei einer Temperatur von über 230°C mit einer Beleuchtungsintensität größer 0,3 kW/m² beleuchtet wird.

13. Vorrichtung nach Anspruch 12, wobei die Temperaturhaltezone (30) derart ausgestaltet ist, dass das Siliziumsubstrat für wenigstens 10s bei einer Temperatur von zwischen 230°C und 450°C gehalten wird.

14. Vorrichtung nach einem der Ansprüche 12 und 13, ferner aufweisend eine Kühlvorrichtung (28) zum aktiven Kühlen des Siliziumsubstrates innerhalb der Abkühlzone (26).

15. Vorrichtung nach Anspruch 14, wobei die Kühlvorrichtung ein Gebläse zum Einblasen von kühlendem Gas in die Abkühlzone (26) aufweist.

## Claims

1. Method for producing a photovoltaic element with stabilised efficiency, comprising the following steps:
providing a silicon substrate;
forming an emitter layer at a surface of the silicon substrate;
forming electrical contacts on the silicon substrate;
**characterised in that** the method further comprises a stabilising treatment step comprising:
introducing hydrogen into the silicon substrate, wherein the hydrogen is introduced at temperatures above 650°C and subsequent cooling to 450°C is carried out with a ramp at a cooling rate above 550°C of at least 10 K/s; and subsequently
generating excess minority charge carriers in the silicon substrate while the silicon substrate is at a temperature of more than 230°C.

2. Method according to claim 1, wherein the stabilisation treatment step further comprises a step of maintaining the silicon substrate within a temperature range of between 230°C and 450°C for a period of at least 10 seconds, preferably at least 30 seconds, after hydrogen has been introduced into the silicon substrate.

3. Method according to claim 2, wherein the excess minority charge carriers are generated in a subsequent method step after the silicon substrate has been maintained within the temperature range of between 230°C and 450°C.

4. Method according to claim 2, wherein the excess minority charge carriers are generated in a common method step together with the maintenance of the silicon substrate within the temperature range of between 230°C and 450°C.

5. Method according to any one of claims 1 to 4, wherein the subsequent cooling to 450°C is carried out with a ramp at a cooling rate above 550°C of at least 20 K/s, more preferably at least 30 K/s, yet more preferably at least 60 K/s.

6. Method according to any one of claims 1 to 5, wherein the excess minority charge carriers are generated by illumination with an illumination intensity greater than 0.3 kW/m², preferably greater than 1 kW/m², more preferably greater than 3 kW/m², with light having wavelengths less than 1180 nm.

7. Method according to any one of claims 1 to 6, wherein the excess minority charge carriers are generated at a temperature of the silicon substrate of between 230°C and 450°C, preferably between 230°C and 400°C, more preferably between 230°C and 350°C and yet more preferably between 230°C and 300°C.

8. Method according to any one of claims 1 to 7, further comprising depositing on at least one surface of the silicon substrate a hydrogen-containing layer which serves as hydrogen source during the introduction of hydrogen into the silicon substrate.

9. Method according to claim 8, wherein the hydrogen-containing layer is a hydrogenated silicon nitride layer.

10. Method according to claim 8 or 9, wherein the hydrogen-containing layer is covered with at least one layer which is less permeable to hydrogen than the hydrogen-containing layer.

11. Method according to any one of claims 1 to 10, wherein the silicon substrate is coated with a hydrogen-containing layer and the silicon substrate is then moved in a continuous furnace through zones whose temperature is suitably controlled.

12. Device for treating a silicon substrate within the context of a production of a photovoltaic element, wherein the device is configured as a continuous furnace (10) to carry out the stabilisation treatment step according to a method according to any one of claims 1 to 11,
wherein the device is provided with a plurality of zones (1, 2, 3, 4, 5; 18, 22, 26, 30, 34) which may be adjusted to different temperatures and comprises an illumination device (36), wherein the temperatures of the zones may be so controlled and the device, including the illumination device, is configured so that a silicon substrate passing through the continuous furnace is first heated for a short time to a temperature above 650°C in a maximum heating zone (22), is then cooled to a temperature below 450°C in a cooling zone (26) at a cooling rate above 550°C of at least 10 K/s and is then maintained at a temperature of between 230°C and 450°C in a temperature maintenance zone (30) and, at the same time or subsequently, the silicon substrate is illuminated at a temperature of at least 230°C with an illumination intensity greater than 0.3 kW/m².

13. Device according to claim 12, wherein the temperature maintenance zone (30) is so configured that the silicon substrate is maintained at a temperature of between 230°C and 450°C for at least 10 seconds.

14. Device according to any one of claims 12 to 13, further comprising a cooling device (28) for actively cooling the silicon substrate within the cooling zone (26).

15. Device according to claim 14, wherein the cooling device comprises a fan for blowing cooling gas into the cooling zone (26).

## Revendications

1. Procédé de fabrication d'un élément photovoltaïque avec un rendement stabilisé, présentant les étapes suivantes :
la préparation d'un substrat en silicium ;
la formation d'une couche émetteur au niveau d'une surface du substrat en silicium ;
la formation de contacts électriques sur le substrat en silicium ;
**caractérisé en ce que** le procédé présente en outre une étape de traitement de stabilisation, présentant :
l'incorporation d'hydrogène dans le substrat en silicium, dans lequel l'hydrogène est incorporé à des températures au-dessus de 650 °C, et un refroidissement ultérieur jusqu'à 450 °C est effectué à l'aide d'une rampe avec une vitesse de refroidissement au-dessus de 550 °C d'au moins 10 K/s ; et ensuite
la génération de porteurs de charge excédentaires minoritaires dans le substrat en silicium, tandis que le substrat en silicium est à une température de plus de 230 °C.

2. Procédé selon la revendication 1, dans lequel l'étape de traitement de stabilisation comprend en outre une étape de maintien du substrat en silicium dans une plage de température entre 230 °C et 450 °C pour une durée d'au moins 10 s, de préférence de 30 s, après que l'hydrogène ait été introduit dans le substrat en silicium.

3. Procédé selon la revendication 2, dans lequel les porteurs de charge excédentaires minoritaires sont générées dans une étape de procédé ultérieure après le maintien du substrat en silicium dans la plage de température entre 230 °C et 450 °C.

4. Procédé selon la revendication 2, dans lequel les porteurs de charge excédentaires minoritaires sont générées dans une étape de procédé commune conjointement avec le maintien du substrat en silicium dans la plage de température entre 230 °C et 450 °C.

5. Procédé selon l'une des revendications 1 à 4, dans lequel le refroidissement ultérieur jusqu'à 450 °C est effectué à l'aide d'une rampe avec une vitesse de refroidissement au-dessus de 550 °C d'au moins 20 K/s, plus préférentiellement d'au moins 30 K/s, plus préférentiellement encore d'au moins 60 K/s.

6. Procédé selon l'une des revendications 1 à 5, dans lequel les porteurs de charge excédentaires minoritaires sont générées par une illumination avec une intensité d'illumination supérieure à 0,3 kW/m², de préférence supérieure à 1 kW/m², plus préférentiellement supérieure à 3 kW/m² à l'aide de lumière avec des longueurs d'onde inférieures à 1180 nm.

7. Procédé selon l'une des revendications 1 à 6, dans lequel les porteurs de charge excédentaires minoritaires sont générées à une température du substrat en silicium entre 230 °C et 450 °C, de préférence entre 230 °C et 400 °C, plus préférentiellement entre 230 °C et 350 °C et plus préférentiellement encore entre 230 °C et 300 °C.

8. Procédé selon l'une des revendications 1 à 7, présentant en outre une précipitation d'une couche contenant de l'hydrogène sur au moins une surface du substrat en silicium, laquelle sert de source d'hydrogène lors de l'incorporation d'hydrogène dans le substrat en silicium.

9. Procédé selon la revendication 8, dans lequel la couche contenant de l'hydrogène est une couche de nitrure de silicium hydrogénée.

10. Procédé selon la revendication 8 ou la revendication 9, dans lequel la couche contenant de l'hydrogène est recouverte au moins d'une couche qui est moins perméable à l'hydrogène que la couche contenant de l'hydrogène.

11. Procédé selon l'une des revendications 1 à 10, dans lequel le substrat en silicium est revêtu d'une couche contenant de l'hydrogène et le substrat en silicium est ensuite passé dans un four continu à travers des zones thermostatées de manière appropriée.

12. Dispositif de traitement d'un substrat en silicium dans le cadre d'une fabrication d'un élément photovoltaique, ledit dispositif étant sous forme d'un four continu (10), pour exécuter l'étape de traitement de stabilisation d'un procédé selon l'une des revendications 1 à 11,
ledit dispositif étant conçu avec une multiplicité de zones thermostatées de manière différente (1, 2, 3, 4, 5; 18, 22, 26, 30, 34) et présentant un dispositif d'éclairage (36), les zones pouvant être thermostatées de telle manière et le dispositif, y compris le dispositif d'éclairage, étant conçu de telle manière, qu'un substrat en silicium traversant le four continu est chauffé dans une zone de chauffage maximale (22), tout d'abord pendant un temps très court à une température au-dessus de 650 °C, puis est refroidi dans une zone de refroidissement (26) avec une vitesse de refroidissement au-dessus de 550 °C d'au moins 10 K/s jusqu'à une température en-dessous de 450 °C, et ensuite, est maintenu dans une zone de maintien de la température (30) à une température entre 230 °C et 450 °C et le substrat de silicium est simultanément ou ultérieurement éclairé à une température au-dessus de 230 °C avec une intensité d'illumination supérieure à 0,3 kW/m².

13. Dispositif selon la revendication 12, dans lequel la zone de maintien de la température (30) est conçue de telle manière que le substrat en silicium est maintenu pendant au moins 10 s à une température entre 230 °C et 450 °C.

14. Dispositif selon l'une des revendications 12 et 13, présentant en outre un dispositif de refroidissement (28) pour le refroidissement actif du substrat en silicium dans la zone de refroidissement (26).

15. Dispositif selon la revendication 14, ledit dispositif de refroidissement présentant un ventilateur permettant l'apport de gaz de refroidissement dans la zone de refroidissement (26).
